# EUROPEAN PATENT SPECIFICATION

(11) **EP 2 006 612 B1**
(45) Date of publication and mention of the grant of the patent: **18.06.2014**
(21) Application number: 07110457.4
(22) Date of filing: 18.06.2007
(51) Int. Cl.: F24J 2/52

(54) **Light-Collecting Base-Body Structure**
Lichtauffangende Basiskörperstruktur
Structure à corps de base de collecte de la lumière

(43) Date of publication of application: 24.12.2008
(73) Proprietor: Atomic Energy Council - Institute of Nuclear Energy Research, Lungtan, Taoyuan, Taiwan (TW)
(72) Inventor: Shin, Hwa-Yuh, 333 Chiaan Village, Lungtan, Taoyuan (TW); Chiu, Hung-Sheng, 333 Chiaan Village, Lungtan, Taoyuan (TW); Cheng, Chieh, 333 Chiaan Village, Lungtan, Taoyuan (TW); Hong, Hwen-Fen, 333 Chiaan Village, Lungtan, Taoyuan (TW); Kuo, Cherng-Tsong, 333 Chiaan Village, Lungtan, Taoyuan (TW)
(74) Representative: Beck, Michael Rudolf

(56) References cited:
- WO-A-98/08117
- AT-B- 411 547
- DE-A1- 4 333 048
- DE-C1- 3 805 422
- US-A- 4 025 786
- US-A- 4 324 227
- US-A- 4 392 009
- US-A- 4 683 634
- US-A- 5 123 968

## Description

### Field of the invention

The present invention relates to a light-collecting base-body structure which is used for solar power generation.

### Description of the Related Art

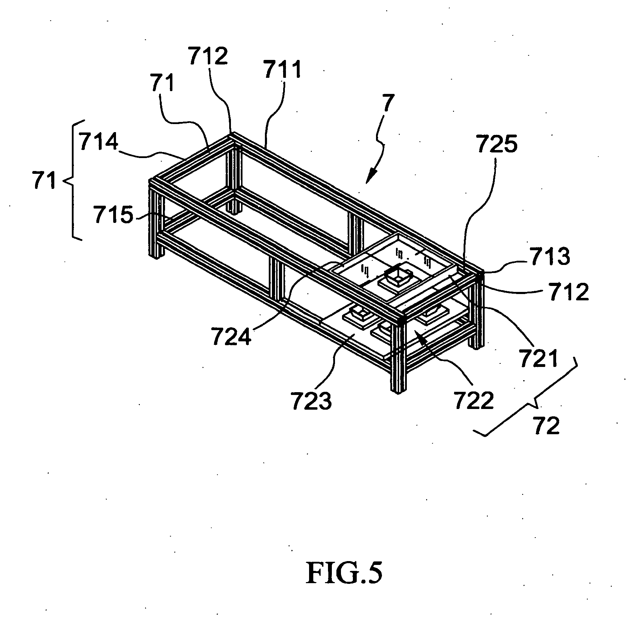

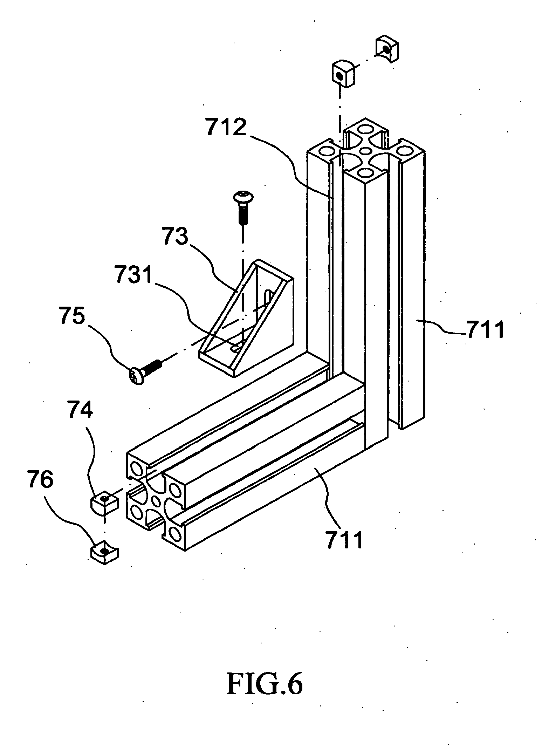

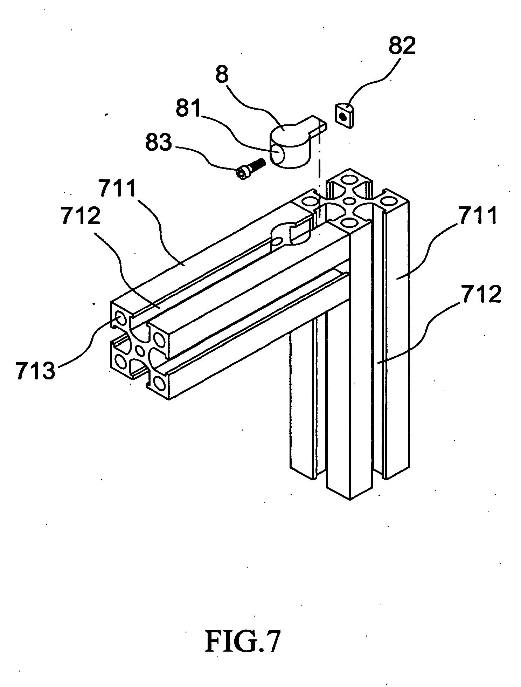

A concentration-type solar power generation apparatus 7, as shown in FIG.5, comprises a carrying frame 71 and at lease one light-collecting unit 72 deposed on the carrying frame 71. The carrying frame 71 comprises a plurality of rod components 711; at least one sliding trough 712 is located on a side surface of the rod component 711; and, the rod component 711 comprises at least one hollow portion 713 to reduce weight. The light-collecting unit 72 comprises a Fresnel lens 721 and a solar cell module 722; the solar cell module 722 is deposed on the carrying frame 71 with a plate component 723; the Fresnel lens 721 is deposed on the carrying frame 71 with a frame set 724; the frame set 724 has a side wing 725 to insert in the sliding trough 712 of the corresponding rod component 71; and, the carrying frame 71 has an upper frame 714 to carry the Fresnel lens 721 and a lower frame 715 to carry the solar cell module 722. As further shown in FIG.6, the carrying frame 71 is assembled with an angle component 73, a female screw 74 and a screw plug 75, where the angle component 73 has a plurality of borings 731 and is adhered to two vertically connected rod components 711; the female screw 74 is set in the sliding trough 712 of the rod component 711; the screw plug 75 is fixed to the female screw 74 through the boring 731 of the angle component 73; the female screw 74 is fixed to the sliding trough 712 coordinated with a washer component 76. Or, as further shown in FIG.7, the carrying frame 71 is assembled with a fixing hole 8, a female screw 82 and a screw plug 83, where the fixing hole 8 is set in the sliding trough 712 of the rod component 711; the female screw is set in the sliding trough 712 of the vertically adjacent rod component 711; and the screw plug 83 is fixed to the female screw 82 through the boring 8 of the fixing hole 8. Thus, a concentration-type solar power generation apparatus 7 is formed.

Although the concentration-type solar power generation apparatus 7 is formed with the above components, its carrying frame 71 uses an angle component 73, a female screw 74, a screw plug 75 and a washer component 76, or a fixing hole 8, a female screw 82 and a screw plug 83, to fix the rod components 711 for assembling a carrying frame 71 so that the working process for assembling the carrying frame 71 becomes complex; the costs are high and the assembling efficiency is low; and the carrying frame 71 obtained is heavy with these fixing components.

A solar panel unit having a first frame for a lens, a second frame for.a solar panel and supporting units for connecting the frames is known from US 4,324,227 A.

Frames structures for machines are known from DE 43 33 048 A1, DE 38 05 422 C1 and AT 411 547 B.

### Summary of the invention

The purpose of the invention is to provide a light-collecting base-body structure that can be assembled more easily and has a low weight and low installation costs.

To achieve the above purpose, the present invention provides a light-collecting base-body structure according to claim 1.

Advantageous embodiments are laid down in further claims.

An inventive liglit-collecting base-body structure may comprise a plurality of first rod bodies, a plurality of second rod bodies, a plurality of connection units and a plurality of supporting units, where the first rod body has a ladder-like gap portion at a side edge; a plurality, of long troughs are located on a side surface and an adjacent side surface of the first and the second rod bodies; each of the first and the second rod bodies has a hollow portion penetrated through the middle; the plurality of connection units are set in the hollow portions of the first and the second rod bodies to connect the first and the second rod bodies to form a first frame and a second frame; the supporting unit comprises two side plates; the side plate is fixed to the first frame and the second frame in between with fixing members to be fixed in the long troughs of the first and the second rod bodies to fix the supporting unit at a place two adjacent first rod bodies or second rod bodies are connected. Accordingly, a novel light-collecting base-body structure is obtained.

### Brief descriptions of the drawings

The present invention will be better understood from the following detailed description of the preferred embodiment according to the present invention, taken in conjunction with the accompanying drawings, in which
FIG.1 is the perspective view showing the preferred embodiment according to the present invention;
FIG. 2A is the explosive view showing the preferred embodiment;
FIG. 2B is the enlarged view of a in FIG. 2A;
FIG. 2C is the enlarged view of b in FIG. 2A;
FIG.3 is the view showing the assembling of the state of use;
FIG.4 is the view showing the state of use;
FIG.5 is the explosive view of the prior art; and
FIG.6 and FIG.7 are the views of assembling the carrying frame of the prior art.

### Description of the preferred embodiment

The following description of the preferred embodiment is provided to understand the features and the structures of the present invention.

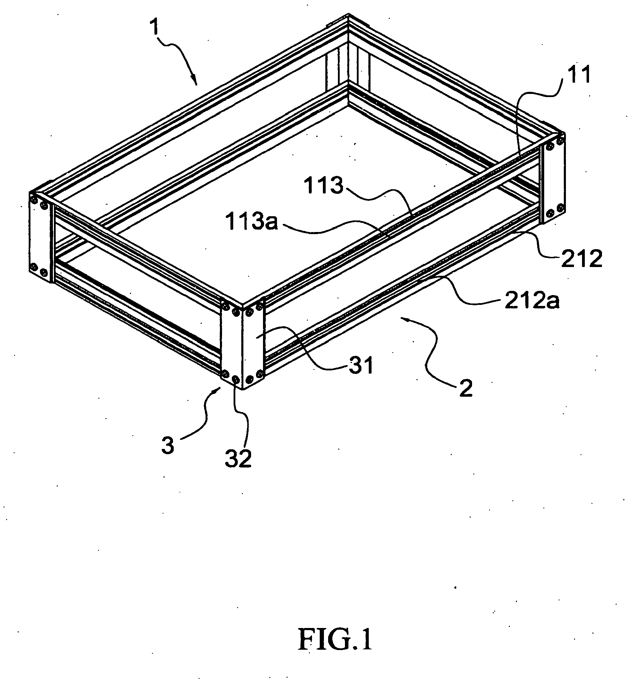

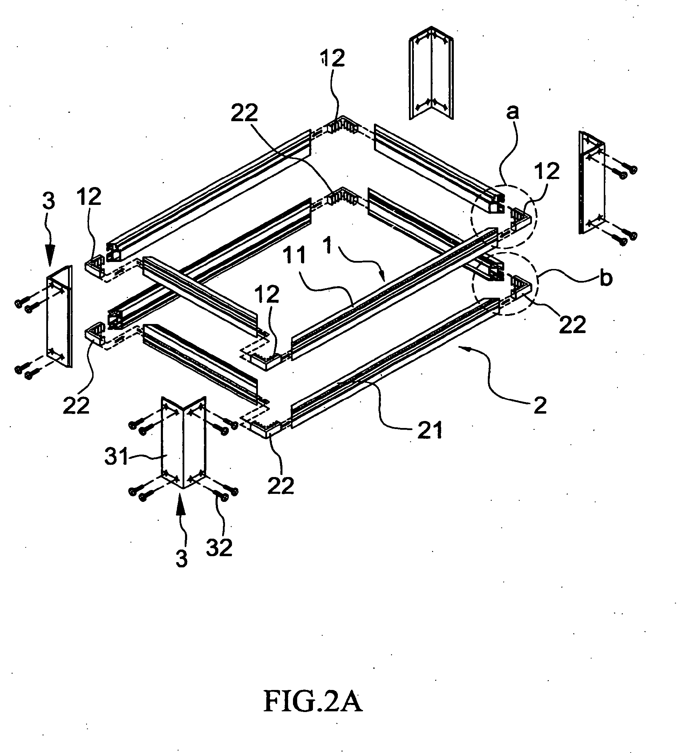

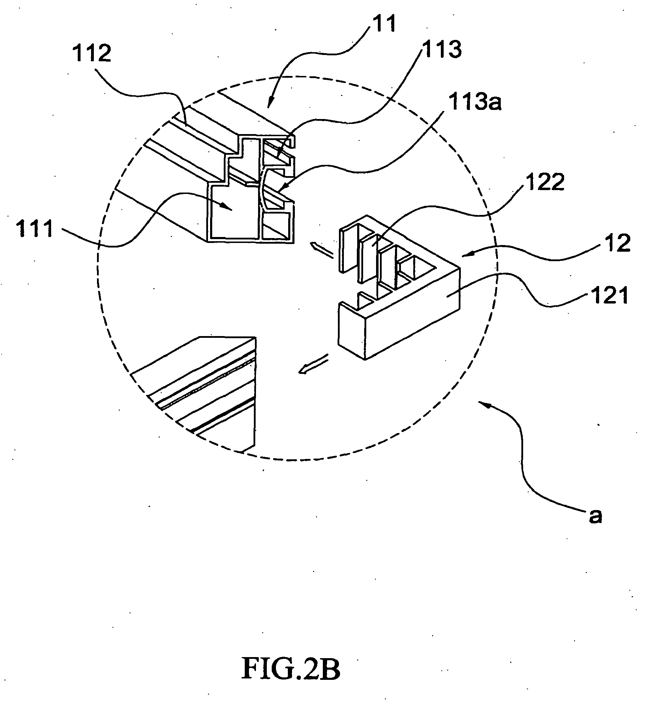

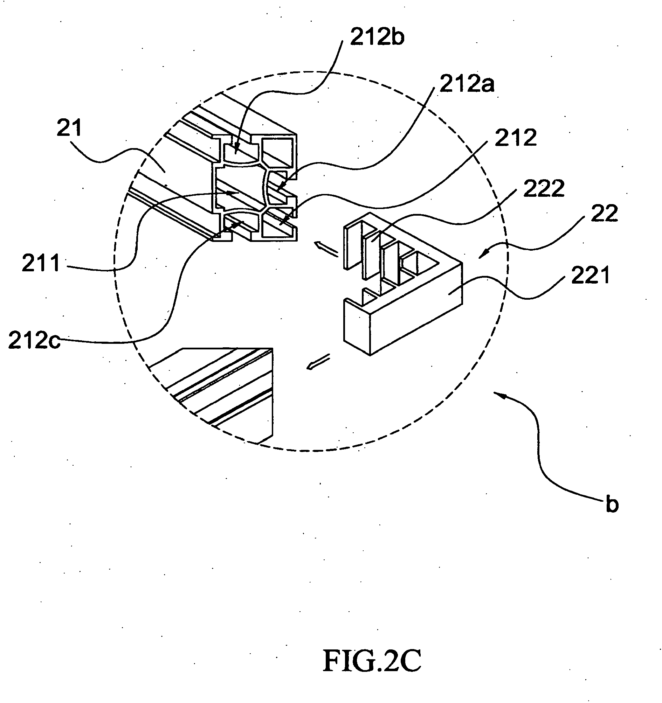

Please refer to FIG.1 to FIG2C, which are a perspective view showing the preferred embodiment according to the present invention; an explosive view showing the preferred embodiment and enlargement views of a and b in FIG.2A. As shown in the figures, the present invention is light-collecting base-body structure, comprising a first frame 1, a second frame 2 and a plurality of supporting units 3, where the working process is simplified for fast assembling and cost and weight are reduced.

The first frame 1 comprises a plurality of first rod bodies 11, each having a hollow portion 111; and a plurality of connection units 12 in the hollow portions 111 of two adjacent first rod bodies 11, where the connection unit 12 has an 'L' shape and comprises two insertion portions 121 which are connected at a side and are inserted into the hollow portions 111 of the first rod bodies 11 separately; each of the two adjacent surfaces of the two insertion portions 121 of the connection unit 12 has a plurality of interference portions 122; a ladder-like gap portion 112 is located at a side edge of the first rod body 11; and a plurality of long troughs 113, 113a is located on a side surface and at least one adjacent side surface of the first rod body 11.

The second frame 2 comprises a plurality of second rod bodies 21, each having a hollow portion 211; and a plurality of connection units 22 in the hollow portions 211 of two adjacent second rod bodies 21, where the connection unit 22 has an 'L' shape and comprises two insertion portions 221 which are connected at a side and are inserted into the hollow portions 211 of the second rod bodies 21 separately; each of the two adjacent surfaces of the two insertion portions 221 of the connection unit 22 has a plurality of interference portions 222; and a plurality of long troughs 212, 212a, 212b, 212c is located on a side surface and at least one adjacent side surface of the second rod body 21.

The supporting unit 3 comprises two side plates 31 connected at a side. The side plate 31 is fixed to the first and the second frames 1, 2 at two ends coordinated with the fixing members 32 to be fixed to the long troughs 113a, 212a of the first and the second rod bodies 11, 21 so that the side plate 31 is fixed at a place the two first rod bodies 11 or the two second rod bodies 21 are connected. Thus, a novel solar energy base-body structure is obtained.

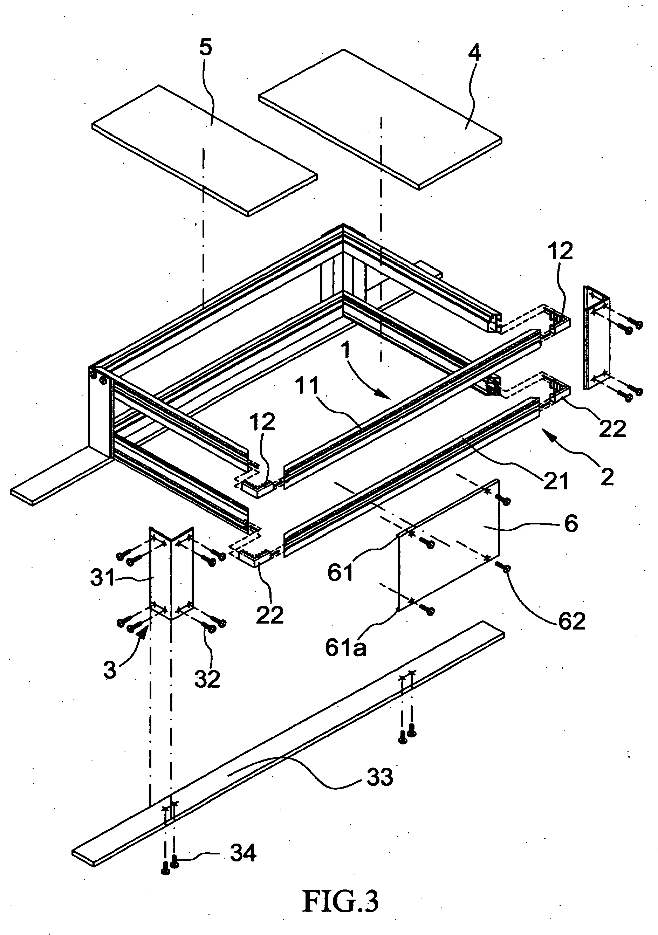

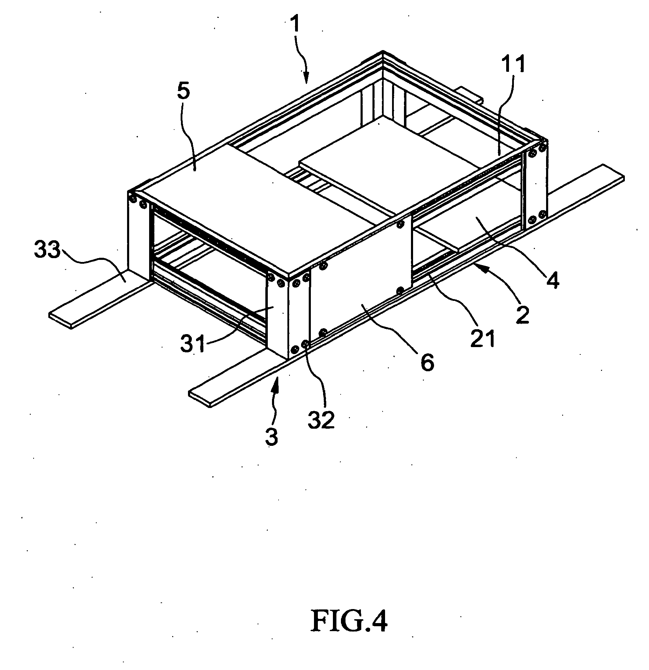

Please refer to FIG.3 and FIG4, which are a view showing an assembling of a state of use; and a view showing the state of use. As shown in the figure, when assembling the present invention, at least four first rod bodies 11 and at least four connection units 12 are obtained. Insertion portions 122 of the connection units 12 are inserted into hollow portions 111 of the first rod bodies 11 from two ends, where the two insertion portions 121 are interfered with inner walls of the hollow portions 111 by the insertion portions 121 to be firmly inserted into the first rod bodies 11. Thus, a first frame 1 is formed.

Then at least four second rod bodies 21 and at least four connection units 22 are obtained. Insertion portions 222 of the connection units 22 are inserted into hollow portions 211 of the second rod bodies 21 from two ends, where the two insertion portions 221 are interfered with inner walls of the hollow portions 111 by the insertion portions 221 to be firmly inserted into the second rod bodies 21. Thus, a second frame 2 is formed.

After the first and the second frames 1, 2 are formed, four supporting units 3 are obtained to be fixed at the four corners of the first and the second frames 1, 2. Each supporting unit 3 has two side plates 31. Two ends of each side plate 31 are fixed to the long troughs 113a, 212a of the first and the second rod bodies 11, 12 coordinated with fixing members 32 so that the supporting units 3 are fixed between the first and the second frames 1,2 and are positioned at the places two adjacent first rod bodies 11 and two adjacent second rod bodies 21 are connected. A solar cell seat 4 is fixed to the long troughs 212b of the second rod bodies 21 of the second frame 2. A lens 5 is set across on corresponding gap portions 112 located at inner side edges of the first rod bodies 11 of the first frame 1. A cap plate 6 is fixed across the first and the second frames 1, 2. The cap plate 6 is slightly bent at the edge to obtain an 'n' shape to set the extension portions 61, 61a of the cap plate 6 in the long troughs 113, 212 of the first and the second rod bodies 11, 21. And the cap plate 6 is fixed to another long troughs 113a, 212a of the first and the second rod bodies 11, 21 coordinated with fixing members 62. Thus, the cap plate 6 is fixed on side surface between the first and the second frames 1, 2. At last, a supporting plate 33 is fixed at bottom of at least one second rod body 21. Two ends of the supporting plate 33 are directly fixed to long troughs 212c of the second rod body 21 with fixing members 34 to firmly set the concentration-type solar energy base body at a required place.

To sum up, the present invention is a solar energy base-body structure, where a first frame and a second frame are formed with rod bodies coordinated with connection units; supporting units are used to fix the first frame and the second frame; and thus, the working process is simplified for fast assembling and cost and weight are reduced.

The preferred embodiment herein disclosed is not intended to unnecessarily limit the scope of the invention. Therefore, simple modifications or variations belonging to the equivalent of the scope of the claims and the instructions disclosed herein for a patent are all within the scope of the present invention.

## Claims

1. A light-collecting base-body structure, comprising:
a first frame (1) for receding a lens (5);
a second frame (2) for receiving solar cells (4); and and
a plurality of supporting units (3) connecting said first and second frame (1,2); wherein the first frame comprises a plurality of first rod bodies (11), each having a hollow portion (111); and the second frame comprises a plurality of second rod bodies (21), each having a hollow portion (211);
**characterized by**
a plurality of L-shaped connection units (12) in the hollow portions (111), each connection unit (12) having two insertion portions (121) that are inserted into the hollow portions (111) of two adjacent first rod bodies (11) thereby connecting them with each other, wherein a gap (112) portion is located at inner side edge of said first rod body (11) and wherein a lens (5) is deposable across on said corresponding gap portions (112);
a plurality of L-shaped connection units (22) in the hollow portions (211), each connection unit (22) having two insertion portions (221) that are inserted into the hollow portions (211) of two adjacent second rod bodies (21) thereby connecting them with each other; and wherein
each supporting unit (3) comprises two side plates (31), wherein each of the side plates (31) of a supporting unit (3) is connected with the first and second frame (1, 2) at the first rod body (11) and the second rod body (21).

2. The light-collecting base-body structure of claim 1, **characterized in that**
each first rod body (11) has a plurality of long troughs (113, 113a);
each second rod body (21) has a plurality of long troughs (212, 212a, 212b. 212c);
wherein said plurality of long troughs (113, 113a) of said first rod body (11) is deposed on a side surface and at least one adjacent side surface of said first rod body;
wherein said plurality of long troughs (212, 212a, 272b, 212c) of said second rod body (21) is deposed on a side surface and at least one adjacent side surface of said second rod body;
wherein said hollow portion (111) of said first rod body (21) and said hollow portion (211) of said second rod body (21) are penetrated through a middle of said first rod body (11) and said second rod body (21), respectively;
wherein said two side plates (31) of said supporting unit (3) are connected with each other at a side, said side plate has two fixing members at each of two opposite ends of said side plate (31), and said side plate (31) is fixed to said long troughs (113, 113a) of said first rod body and said long troughs (212, 212a, 212b, 212c) of said second rod body coordinated with said fixing members;
wherein said supporting unit (3) is fixed at a place where two adjacent said first rod bodies (11) are connected; and
wherein said supporting unit (3) is fixed at a place where two adjacent said second rod bodies (21) are connected.

3. The structure according to claim 1 or 2, **characterised in that** a solar cell seat is fixed on said long trough (212, 212a, 212b, 212c) of said second rod body (21).

4. The structure according to claim 2 or 3, **characterized in that** a cap plate (6) is fixed between said long trough (113, 113a) of said first rod body (11) and said long trough (212, 212a, 212b, 212c) of corresponding said second rod body (21); and wherein said cap plate (6) is located at a side of said supporting unit (3).

5. The structure according to one of claims 1 to 4, **characterized in that** the connection unit (12, 22) comprises two insertion portions (121, 221) connected with each other at a side; and
two adjacent surfaces of two said insertion portions (121, 221) of said connection unit have a plurality of interference portions (122, 222) on each surface.

6. The structure according to one of claims 1 to 5, **characterized in that** a supporting plate (33) is fixed on at least one outside surface of said supporting unit (3).

7. The structure according to one of claims 1 to 6, **characterized in that** each of two adjacent surfaces of two said insertion portions (121, 221) of said connection un it (12, 22) has a plurality of interference portions (122, 222).

## Patentansprüche

1. Lichtauffangende Basiskörperstruktur, umfassend:
einen ersten Rahmen (1) zum Aufnehmen einer Linse (5);
einen zweiten Rahmen (2) zum Aufnehmen von Solarzellen (4); und
eine Vielzahl von Trageeinheiten (3), die den ersten und zweiten Rahmen (1, 2) miteinander verbinden;
wobei der erste Rahmen eine Vielzahl von ersten Stangenkörper (11) umfasst, die jeweils einen hohlen Abschnitt (111) aufweisen; und der zweite Rahmen eine Vielzahl von zweiten Stangenkörper (21) umfasst, die jeweils einen hohlen Abschnitt (211) aufweisen;
**gekennzeichnet durch**
eine Vielzahl von L-förmigen Verbindungseinheiten (12) in den hohlen Abschnitten (111), wobei jede Verbindungseinheit (12) zwei Einschubabschnitte (121) aufweist, die in die hohlen Abschnitte (111) von zwei angrenzenden ersten Stangenkörper (11) eingesetzt sind, um diese miteinander zu verbinden, wobei sich ein Spaltabschnitt (112) an einer Innenseitenkante des ersten Stangenkörpers (11) befindet und wobei eine Linse (5) über diese korrespondierenden Spaltabschnitte (112) anordenbar ist;
eine Vielzahl von L-förmigen Verbindungseinheiten (22) in den hohlen Abschnitten (211), wobei jede Verbindungseinheit (22) zwei Einschubaschnitte (221) aufweist, die in die hohlen Abschnitte (211) von zwei angrenzenden zweiten Stangenkörper (21) eingesetzt ist, um diese miteinander verbinden;
und wobei
jede Trageeinheit (3) zwei Seitenplatten (31) umfasst, wobei jede der Seitenplatten (31) einer Trageeinheit (3) mit dem ersten und zweiten Rahmen (1, 2) an dem ersten Stangenkörper (11) und dem zweiten Stangenkörper (21) verbunden ist.

2. Lichtauffangende Basiskörperstruktur nach Anspruch 1, **dadurch gekennzeichnet, dass**
jeder erste Stangenkörper (111) eine Vielzahl von langen Rinnen (113, 113a) aufweist;
jeder zweite Stangenkörper (21) eine Vielzahl von langen Rinnen (212, 212a, 212b, 212c) aufweist;
wobei die Vielzahl von langen Rinnen (113, 133a) des ersten Stangenkörpers (11) an einer Seitenfläche und mindestens einer angrenzenden Seitenfläche dieses ersten Stangenkörpers angeordnet ist;
wobei die Vielzahl von langen Rinnen (212, 212a, 212b, 212c) des zweiten Stangenkörpers (21) an einer Seitenfläche und mindestens einer angrenzenden Seitenfläche dieses zweiten Stangenkörpers angeordnet ist;
wobei der hohle Abschnitt (111) des ersten Stangenkörpers (21) und der hohle Abschnitt (211) des zweiten Stangenkörpers (21) durch eine Mitte des ersten Stangenkörpers (11) bzw. des zweiten Stangenkörpers (21) verlaufen;
wobei die zwei Seitenplatten (31) der Trageeinheit (3) an einer Seite miteinander verbunden sind, die Seitenplatte jeweils zwei Befestigungselemente an zwei entgegensetzten Enden dieser Seitenplatte (31) aufweist,
und die Seitenplatte (31) mithilfe der Befestigungselemente an den langen Rinnen (113, 133a) des ersten Stangenkörpers und den langen Rinnen (212, 212a, 212b, 212c) des zweiten Stangenkörpers fixiert ist;
wobei die Trageeinheit (3) an einer Stelle fixiert ist, an der zwei angrenzende erste Stangenkörper (11) miteinander verbunden sind; und
wobei die Trageeinheit (3) an einer Stelle fixiert ist, an der zwei angrenzende zweite Stangenkörper (21) miteinander verbunden sind.

3. Struktur nach Anspruch 1 oder 2, **dadurch gekennzeichnet, dass** ein Solarzellensitz an der langen Rinne (212, 212a, 212b, 212c) des zweiten Stangenkörpers (21) befestigt ist.

4. Struktur nach Anspruch 2 oder 3, **dadurch gekennzeichnet, dass** eine Deckplatte (6) zwischen der langen Rinne (113, 113a) des ersten Stangenkörpers (11) und der langen Rinne (212, 212a, 212b, 212c) des entsprechenden zweiten Stangenkörpers (21) fixiert ist; und wobei die Deckplatte (6) an einer Seite der Trageeinheit (3) angeordnet ist.

5. Struktur nach einem der Ansprüche 1 bis 4, **dadurch gekennzeichnet, dass** die Verbindungseinheit (12, 22) zwei Einschubabschnitte (121, 221) umfasst, die an einer Seite miteinander verbunden sind; und
zwei angrenzende Flächen von zwei Einschubabschnitten (121, 221) der Verbindungseinheit eine Vielzahl von Presssitzabschnitten (122, 222) auf jeder Fläche aufweisen.

6. Struktur nach einem der Ansprüche 1 bis 5, **dadurch gekennzeichnet, dass** eine Trägerplatte (33) an mindestens einer Außenfläche der Trageeinheit (3) befestigt ist.

7. Struktur nach einem der Ansprüche 1 bis 6, **dadurch gekennzeichnet, dass** jede von zwei angrenzenden Flächen der zwei Einschubabschnitte (121, 221) der Verbindungseinheit (12, 22) eine Vielzahl von Presssitzabschnitten (122, 222) aufweist.

## Revendications

1. Structure à corps de base de collecte de la lumière comprenant :
un premier cadre (1) pour recevoir une lentille (5) ;
un second cadre (2) pour recevoir des cellules solaires (4) ; et
une pluralité d'unités de support (3) reliant ledit premier et ledit second cadre (1, 2);
le premier cadre comprenant une pluralité de premiers corps en tige (11), chacun ayant une portion creuse (111); et le second cadre comprenant une pluralité de seconds corps en tige (21), chacun ayant une portion creuse (211),
**caractérisée par**
une pluralité d'unités de liaison en forme de L (12) dans les portions creuses (111), chaque unité de liaison (12) ayant deux portions d'insertion (121) qui sont insérées dans les portions creuses (111) de deux premiers corps en tige adjacents (11) en les reliant ainsi l'un à l'autre, une portion d'espace (112) étant située sur un bord latéral intérieur dudit premier corps en tige (11) et une lentille (5) étant déposable sur lesdites portions d'espace correspondantes (112);
une pluralité d'unités de liaison en forme de L (22) dans les portions creuses (211), chaque unité de liaison (22) ayant deux portions d'insertion (221) qui sont insérées dans les portions creuses (211) de deux seconds corps en tige adjacents (21) en les reliant ainsi l'un à l'autre ;
et dans laquelle
chaque unité de support (3) comprend deux plaques latérales (31), chacune des plaques latérales (31) d'une unité de support (3) est reliée au premier et au second cadre (1, 2) sur le premier corps en tige (11) et le second corps en tige (21).

2. Structure à corps de base de collecte de la lumière selon la revendication 1, **caractérisée en ce que** chaque premier corps en tige (11) a une pluralité de longues gouttières (113, 113a), chaque second corps en tige (21) a une pluralité de longues gouttières (212, 212a, 212b, 212c), ladite pluralité de longues gouttières (113, 113a) dudit premier corps en tige (11) étant déposée sur une surface latérale et au moins une surface latérale adjacente dudit premier corps en tige, ladite pluralité de longues gouttières (212, 212a, 212b, 212c) dudit second corps en tige (21) étant déposée sur une surface latérale et au moins une surface latérale adjacente dudit second corps en tige, ladite portion creuse (111) dudit premier corps en tige (21) et ladite portion creuse (211) dudit second corps en tige (21) étant pénétrées respectivement par un milieu dudit premier corps en tige (11) et dudit second corps en tige (21), lesdites deux plaques latérales (31) de ladite unité de support (3) étant reliées l'une à l'autre sur un côté, ladite plaque latérale ayant deux éléments de fixation sur chacune des deux extrémités opposées de ladite plaque latérale (31) et ladite plaque latérale (31) étant fixée sur lesdites longues gouttières (113, 113a) dudit premier corps en tige et lesdites longues gouttières (212, 212a, 212b, 212c) dudit second corps en tige étant coordonnées aux éléments de fixation mentionnés, ladite unité de support (3) étant fixée à un endroit où deux premiers corps en tige adjacents mentionnés (11) sont reliés et ladite unité de support (3) étant fixée à un endroit où deux seconds corps en tige adjacents (11) sont reliés.

3. Structure selon la revendication 1 ou 2, **caractérisée en ce qu'**un siège de cellule solaire est fixé sur ladite longue gouttière (212, 212a, 212b, 212c) dudit second corps en tige (21).

4. Structure selon la revendication 2 ou 3, **caractérisée en ce qu'**une plaque de couverture (6) est fixée entre ladite longue gouttière (113, 113a) dudit premier corps en tige (11) et ladite longue gouttière (212, 212a, 212b, 212c) dudit second corps en tige (21) et ladite plaque de couverture (6) étant située sur un côté de ladite unité de support (3).

5. Structure selon l'une des revendications 1 à 4, **caractérisée en ce que** l'unité de liaison (12 ,22) comprend deux portions d'insertion (121, 221) reliées l'une à l'autre sur un côté et deux surfaces adjacentes desdites deux portions d'insertion (121, 221) de ladite unité de liaison ont une pluralité de portions d'interférence (122, 222) sur chaque surface.

6. Structure selon l'une des revendications 1 à 5, **caractérisée en ce qu'**une plaque de support (33) est fixée sur au moins une surface extérieure de ladite unité de support (3).

7. Structure selon l'une des revendications 1 à 6, **caractérisée en ce que** chacune de deux surfaces adjacentes desdites deux portions d'insertion (121, 221) de ladite unité de liaison (12, 22) a une pluralité de portions d'interférence (122, 222).
